# FASCICULE DE BREVET EUROPEEN

(11) **EP 0 848 258 B1**
(45) Date de publication et mention de la délivrance du brevet: **09.07.2008**
(21) Numéro de dépôt: 97402909.2
(22) Date de dépôt: 03.12.1997
(51) Int. Cl.: G01R 1/02, G01R 1/20

(54) **Appareil de mesure pour un compteur d'électricité**
Messanordnung für Elektrizitätszähler
Measuring appliance for electricity meter

(30) Priorité: 13.12.1996 FR 9615326
(43) Date de publication de la demande: 17.06.1998
(73) Titulaire: Actaris S.A.S., 92100 Boulogne-Billancourt (FR)
(72) Inventeur: Hamard, Guillaume, 75014 Paris (FR); Le Hetet, Bernard, 86000 Poitiers (FR); Duranceau, Jean-François, 86170 Avanton (FR)
(74) Mandataire: Feray, Valérie

(56) Documents cités:
- EP-A- 0 030 186
- FR-A- 2 391 474

## Description

La présente invention concerne un appareil de mesure destiné à être branché sur un circuit de mesure d'un compteur d'électricité comprenant un shunt pourvu d'une première et d'une deuxième borne de tension disposée sur un bord du shunt pour fournir une tension image du courant électrique traversant le shunt, la partie du shunt entre les deux bornes étant sensiblement plate.

Dans le domaine du comptage d'électricité, le remplacement des compteurs électromécaniques par des compteurs électroniques a fait apparaître plusieurs techniques pour extraire un signal représentatif du courant pouvant être utilisé pour le calcul de la puissance électrique consommée, y compris l'utilisation des cellules à effet Hall, des transformateurs de mesures et des shunts.

Le premier brevet qui décrit un compteur d'électricité utilisant un shunt comme élément de mesure est le brevet français délivré sous le n° 2391474 au nom de Schlumberger Industries S.A. Ce brevet énonce quelques principes fondamentaux, notamment, l'utilisation d'un circuit de mesure fonctionnant à la tension de la phase ainsi qu'un shunt ayant une première et une seconde borne de tension pour fournir une tension représentative du courant dans la phase. Le shunt est également pourvu d'une troisième borne apte à fournir un courant d'alimentation du circuit de mesure.

Un exemple de construction physique d'un shunt est décrit dans le brevet européen délivré sous le n° 0030186 au nom de Schlumberger Industries S.A. Le shunt décrit dans ce brevet comprend une boucle de compensation destinée à compenser les erreurs de mesures induites par le champ magnétique du shunt. Ce dispositif possède certains avantages par rapport aux dispositifs existants de l'époque. Cependant, un assemblage relativement complexe est nécessaire au niveau de la connexion des bornes de tensions du shunt au circuit de mesure du compteur.

Dans ce contexte, la présente invention a pour but de proposer un appareil de mesure constitué d'un shunt de structure simple, susceptible d'être produit en masse, à un prix relativement faible, et qui ne possède pas les inconvénients des dispositifs connus.

L'appareil de mesure de la présente invention se caractérise par le fait que l'appareil de mesure comprend une limande de forme sensiblement plate et rectangulaire incorporant un premier et un deuxième fil de connexion et disposée sensiblement parallèle à la surface plate du shunt, les terminaux d'entrée des fils de connexion étant disposés sur un des bords de la limande et reliés aux bornes de tension du shunt et les terminaux de sortie des fils de connexion étant disposés sur un deuxième bord de la limande pour être reliés à un circuit de mesure d'un compteur.

De préférence, le shunt est pourvu d'une troisième borne de tension apte à fournir une tension d'alimentation, celle-ci étant disposée sur le même bord du shunt que celui de la première et deuxième bornes de tension, la limande étant également pourvue d'un troisième fil de connexion possédant un terminal d'entrée disposé sur le premier bord de la limande et branché à la troisième borne de tension ainsi qu'un terminal de sortie placé sur le deuxième bord de la limande et apte à être branché au circuit de mesure pour lui fournir un courant d'alimentation.

Dans un mode de réalisation, une partie du shunt entre la première et la deuxième borne est constituée d'un matériau possédant une résistance relativement élevée, la mesure de tension étant effectuée par rapport au courant traversant cette partie du shunt. Par exemple, cette partie du shunt peut être constituée d'un matériau tel que le manganin.

Etant donné le coût élevé de ce matériau, et pour des raisons d'échauffement, il est préférable que, seule la partie du shunt utilisée pour mesurer le courant soit constituée de ce matériau, les autres parties du shunt étant constituées d'un matériau moins cher, tel que par exemple, le cuivre. La soudure entre la partie de mesure et les autres parties du shunt peut être effectuée par bombardement d'électrons.

Dans un mode de réalisation, les bornes de tension du shunt sont disposées sur les parties du shunt ayant une résistance moins élevée autour de la partie de mesure. Ce mode de réalisation possède l'avantage que des défauts dans la liaison entre la partie de mesure et les autres parties du shunt seront détectés pendant la phase de calibration. Cependant, dans une autre réalisation les bornes de tension peuvent être formées directement sur la partie de mesure.

Dans un mode de réalisation préféré, la limande est disposée dans un plan vertical sensiblement parallèle au plan de la surface du shunt, le premier fil de connexion étant disposé sensiblement à la verticale et perpendiculaire à la direction du courant traversant le shunt, le deuxième fil étant disposé en diagonale par rapport au premier fil pour traverser la partie de la limande située immédiatement au-dessus de la partie de mesure du shunt.

Cette disposition des fils de connexion possède des avantages notamment en ce qui concerne la compensation des courants induits dans les fils par le champ magnétique du shunt ainsi que des champs magnétiques externes. D'autres modes de réalisation sans compensation sont possibles, par exemple dans le cas ou le deuxième fil est également aligné suivant la verticale, perpendiculaire à la direction du courant dans le shunt. Or, ces modes de réalisation sont susceptibles d'erreurs de mesure dues aux courants induits dans les fils.

Dans un certain mode de réalisation, le shunt est découpé en forme de "U" dans une bande métallique, les membres du shunt qui définissent l'entrée et la sortie du shunt étant courbés par la suite pour être sensiblement perpendiculaires au plan de la partie de mesure du shunt. Ce mode de réalisation permet la fabrication du shunt à un prix relativement bas et facilite l'installation du shunt sur la surface d'une carte électronique.

De préférence, la limande comprend un quatrième fil de connexion apte à relier le circuit de mesure au fil neutre, les terminaux d'entrée et de sortie du quatrième fil étant disposés sur le deuxième bord de la limande pour relier le circuit de mesure à un cavalier de neutre disposé en dessous du shunt. Le shunt et le cavalier peuvent être également logés dans un support en plastique avant d'être installé sur une carte électronique.

Un mode de réalisation de l'invention sera maintenant décrit à titre d'exemple non limitatif en référence aux dessins annexés sur lesquels :
- la figure 1 est une première vue en perspective d'un appareil de mesure suivant la présente invention.
- la figure 2 est une vue en perspective de la limande de la figure 1.
- la figure 3 est une vue en perspective montrant le côté caché de l'appareil de la figure 1.

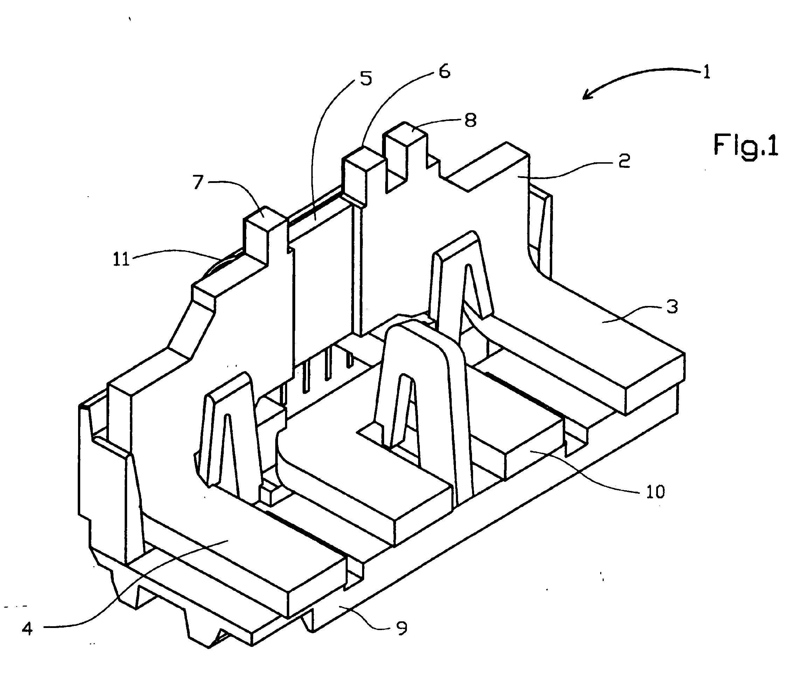

En se référant à la figure 1, l'appareil de mesure 1 de la présente invention comprend un shunt 2 possédant une entrée 3 et une sortie 4, une première et une deuxième borne de tension 6 et 7 disposées de part et d'autres d'une partie de mesure 5 et une troisième borne de tension 8. Le shunt 2 est reçu dans un support en plastique qui contient également un cavalier de mesure 10 relié au neutre du réseau électrique. L'appareil de mesure comprend aussi une limande 11 fixée au shunt et aux bornes de tension.

Le shunt 2 est découpé dans une bande métallique constituée de deux métaux, le manganin et le cuivre, la partie de mesure 5 du shunt étant en manganin et les autres parties en cuivre. Le manganin est choisi de préférence grâce à sa stabilité par rapport à des changements de température. Cependant d'autres matériaux peuvent être utilisés, par exemple, constantin. Le cuivre peut être également remplacé par le cuprofor. Le shunt est découpé en forme d'U et les membres du shunt 3 et 4 sont successivement courbés pour être perpendiculaires au plan de la partie de mesure. La soudure des deux parties en manganin et en cuivre est effectuée par bombardement d'électrons.

Le shunt 2 est utilisé comme élément d'un compteur d'électricité de type électronique et branché en série avec un fil actif du réseau de distribution d'énergie. Le courant circulant dans le fil provoque l'apparition d'une tension proportionnelle à ce courant entre la première et la deuxième borne de tension 6 et 7. La tension représentative du courant est appliquée au circuit de mesure du compteur en tant que signal de donnée destiné à être traité par celui-ci. Le conducteur d'alimentation du circuit est relié à la borne d'alimentation 8 du shunt disposée en amont des bornes de tension 6 et 7 afin de s'assurer que le courant utilisé par le circuit ne traverse pas la partie de mesure et par conséquent n'affecte pas la tension d'alimentation appliquée au circuit. Le signal de la borne d'alimentation est également traité par le circuit de mesure pour déterminer la tension du fil actif du réseau.

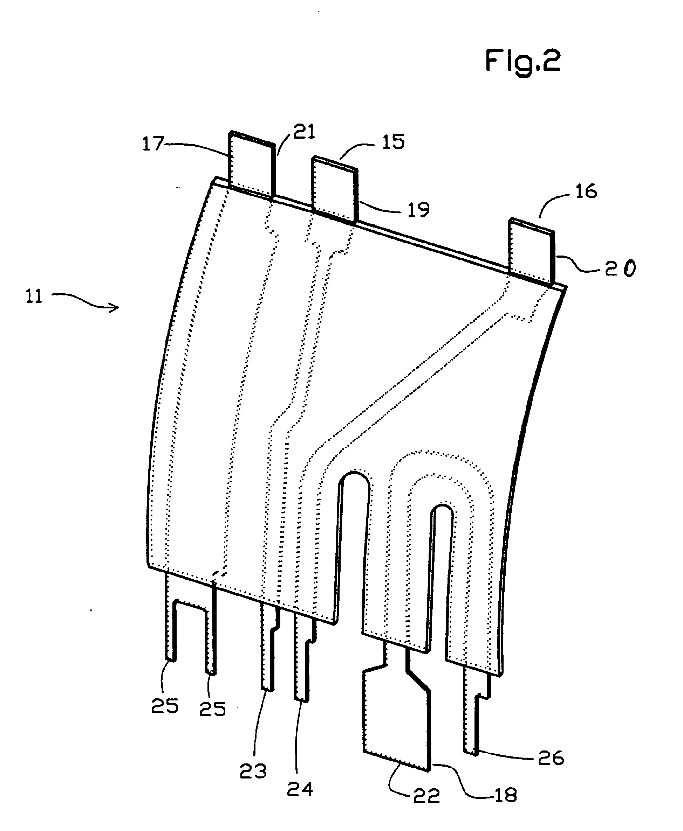

La connexion entre le shunt et le circuit de mesure, qui n'est pas montré mais qui est disposé en dessous de l'appareil de mesure, est effectuée par la limande 11 dont la structure est représentée en détail à la figure 2.

La limande 11 est fabriquée en plastique et incorpore un premier et un deuxième fil de connexion 15, 16 reliés à la première et la deuxième bornes de tension 6, 7 du shunt, un troisième fil de connexion 17 qui est relié à la borne d'alimentation 8 du shunt et un quatrième fil de connexion 18 qui est relié au cavalier du fil de neutre 10.

Les fils de connexion 15 à 18 sont reliés aux bornes de tension du shunt et le cavalier du fil de neutre par les terminaux d'entrée 19 à 22 . La connexion au circuit de mesure du compteur est assurée par les terminaux 23 à 26 qui sont reçus dans une carte électronique comprenant les composants du circuit de mesure.

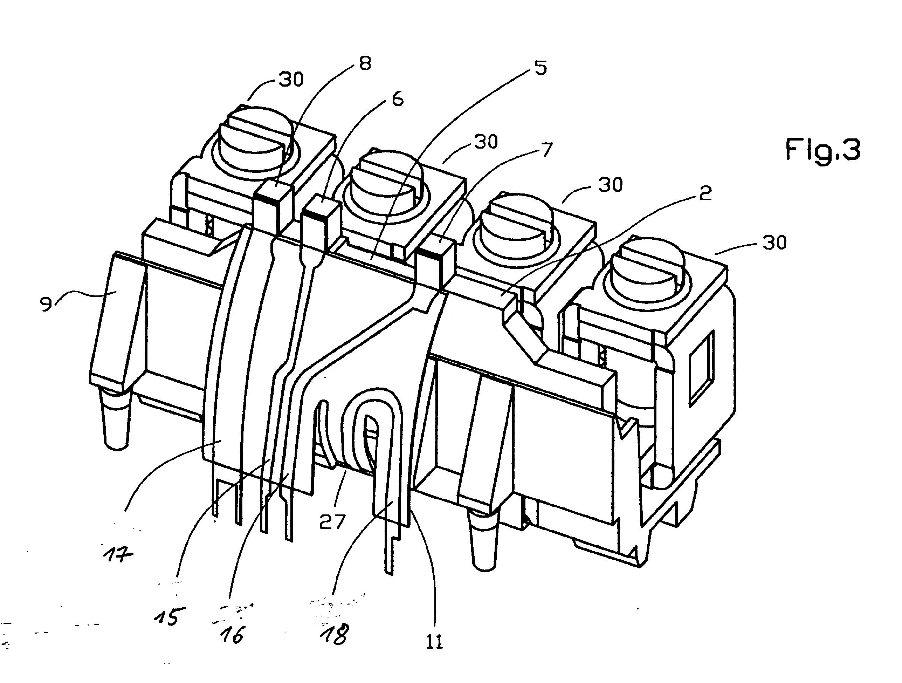

Les terminaux d'entrée 19 à 22 sont soudés sur le shunt et le cavalier du fil de neutre par ultrasons. Dans d'autres modes de réalisation, la soudure peut être effectuée par une soudure à l'étain. Le shunt et le cavalier sont disposés sur une ligne de production et la limande est positionnée en dessous. La soudure étant effectuée, le shunt et le cavalier sont ensuite logés dans le support en plastique. La partie de la limande reliée au fil de neutre est courbée pour permettre l'installation du cavalier dans le support, ainsi que représenté par la partie 27 de la figure 3.

Comme il est représenté sur la figure 2, les terminaux d'entrée 19 à 21 des fils de connexion 15 à 17 sont disposés sur un des bords de la limande et les terminaux de sortie 23 à 25 sur un autre bord. Par contre, les terminaux d'entrée 22 et de sortie 26 du fil de connexion 18 sont disposés sur le même bord pour permettre la disposition du cavalier en dessous du shunt.

En se référant aux figures 2 et 3, on voit que la limande 11 est disposée sur un plan sensiblement parallèle au plan vertical de la surface du shunt. Le premier fil 15 est disposé sensiblement à la verticale de la partie de mesure et perpendiculairement à la direction du courant traversant le shunt. Le deuxième fil 16 est disposé en diagonale par rapport au premier fil 15 et traverse la partie de la limande située immédiatement en dessus de la partie de la mesure du shunt.

Cette disposition des fils de connexion neutralise les effets du champ magnétique du shunt, notamment le champ magnétique existant autour de la partie de mesure du shunt, ainsi que les effets des champs magnétiques externes.

La figure 3 montre également les plots de connexion 30 de l'appareil qui assurent la connexion des fils du réseau distributeur et du réseau consommateur aux éléments de l'appareil de mesure.

L'appareil de mesure qui est montré dans les figures 1 et 3 possède l'avantage qu'il peut être soudé à la vague au circuit de mesure grâce au fait que ce composant est un composant traversant, c'est-à-dire, un composant dans lequel les terminaux de sortie traversent le circuit imprimé du circuit mesure.

## Revendications

1. Appareil de mesure destiné à être branché sur un circuit de mesure (1) d'un compteur d'électricité comprenant un shunt (2) pourvu d'une première et d'une deuxième borne de tension (6,7) disposées sur un bord du shunt (2) pour fournir une tension image du courant électrique traversant le shunt (2), la partie du shunt (2) entre les deux bornes (6,7) étant sensiblement plate, l'appareil étant **caractérisé par le fait qu'**il comprend une limande (11) de forme sensiblement plate et rectangulaire incorporant un premier et un deuxième fil de connexion (15,16) et disposée sensiblement parallèle à la surface plate du shunt (2), les terminaux d'entrée des fils de connexion (19,20) étant disposés sur un des bords de la limande et reliés aux bornes de tension (6,7) du shunt (2) et les terminaux de sortie des fils de connexion (23,24) étant disposés sur un deuxième bord de la limande pour être reliés à un circuit de mesure d'un compteur.

2. Appareil de mesure selon la revendication 1, et dans lequel le shunt (2) est pourvu d'une troisième borne de tension (8) apte à fournir une tension d'alimentation, celle-ci étant disposée sur le même bord du shunt (2) que celui de la première et deuxième bornes de tension, la limande (11) étant également pourvue d'un troisième fil de connexion (17) possédant un terminal d'entrée (21) disposé sur le premier bord de la limande (11) et branché à la troisième borne de tension (8) ainsi qu'un terminal de sortie (25) placé sur le deuxième bord de la limande (11) et apte à être branché au circuit de mesure pour lui fournir un courant d'alimentation.

3. Appareil de mesure selon la revendication 1 ou 2, et dans lequel une partie du shunt (5) entre la première et la deuxième borne (6,7) est constituée d'un matériau possédant une résistance relativement élevée, la mesure de tension étant effectuée par rapport au courant traversant cette partie du shunt.

4. Appareil de mesure selon la revendication 3, et dans lequel le shunt (2) comprend une partie de mesure (5) possédant une résistance élevée, disposée entre deux parties qui possédent une résistance moins élevée, la première et la deuxième borne de tension (6,7) étant disposées sur les deux parties autour de la partie de mesure.

5. Appareil de mesure selon l'une quelconque des revendications 1 à 4, et dans lequel la limande (11) est disposée dans un plan vertical sensiblement parallèle au plan de la surface du shunt (2), le premier fil de connexion (15) étant disposé sensiblement à la verticale et perpendiculaire à la direction du courant traversant le shunt, le deuxième fil (16) étant disposé en diagonale par rapport au premier fil (15) pour traverser la partie de la limande située immédiatement en dessus de la partie de mesure du shunt.

6. Appareil de mesure selon l'une quelconque de revendications 1 à 5, et dans lequel le shunt (2) est découpé en forme de "U" dans une bande métallique, les membres du shunt qui définissent l'entrée (3) et la sortie (4) du shunt (2) étant courbés par la suite pour être sensiblement perpendiculaires au plan de la partie de mesure du shunt.

7. Appareil de mesure selon l'une quelconque des revendications 1 à 6, et dans lequel la limande (11) comprend un quatrième fil (18) de connexion apte à relier le circuit de mesure au fil de neutre (10), les terminaux d'entrée et de sortie (22,26) du quatrième fil étant disposés sur le deuxième bord de la limande (11) pour relier le circuit de mesure à un cavalier du fil de neutre disposé au-dessous du shunt (2).

8. Appareil de mesure selon l'une quelconque des revendications 1 à 7, et dans lequel le shunt (2) et le cavalier du fil de neutre (10) sont logés dans un support plastique.

## Claims

1. A measuring apparatus designed to be connected on a measuring circuit (1) of an electricity meter comprising a shunt (2) provided with a first and a second voltage terminal (6,7) arranged on one edge of the shunt (2) to provide an image voltage of the electrical current going through the shunt (2), the part of the shunt (2) between the two terminals (6,7) being substantially flat, the apparatus being **characterized by** the fact that it comprises a flat jumper (11) having a substantially flat and rectangular shape incorporating a first and a second connecting wire (15, 16) and arranged substantially parallel to the flat surface of the shunt (2), the input terminals of the connecting wires (19, 20) being arranged on one of the edges of the flat jumper and connected to the voltage terminals (6, 7) of the shunt (2) and the output terminals of the connecting wires (23, 24) being arranged on a second edge of the flat jumper to be connected to a measuring circuit of a meter.

2. The measuring apparatus according to claim 1, and wherein the shunt (2) is provided with a third voltage terminal (8) able to provide a supply voltage, this being arranged on the same edge of the shunt (2) as that of the first and second voltage terminals, the flat jumper (11) also being provided with a third connecting wire (17) having an input terminal (21) arranged on the first edge of the flat jumper (11) and connected to the third voltage terminal (8) as well as an output terminal (25) placed on the second edge of the flat jumper (11) and able to be connected to the measuring circuit in order to provide it with a supply current.

3. The measuring apparatus according to claim 1 or 2, and wherein one part of the shunt (5) between the first and the second terminal (6, 7) is made up of a material having a relatively high resistance, the voltage measurement being done in relation to the current going through this part of the shunt.

4. The measuring apparatus according to claim 3, and wherein the shunt (2) comprises a measuring part (5) having a high resistance, arranged between two parts which have a less high resistance, the first and the second voltage terminal (6, 7) being arranged on the two parts around the measuring part.

5. The measuring apparatus according to any one of claims 1 to 4, and wherein the flat jumper (11) is arranged in a vertical plane substantially parallel to the plane of the surface of the shunt (2), the first connecting wire (15) being arranged substantially above and perpendicular to the direction of the current going through the shunt, the second wire (16) being arranged diagonally relative to the first wire (15) to go through the part of the flat jumper located immediately above the measuring part of the shunt.

6. The measuring apparatus according to any one of claims 1 to 5, and wherein the shunt (2) is carved into a "U" shape in a metallic strip, the members of the shunt which define the input (3) and the output (4) of the shunt (2) subsequently being curved to be substantially perpendicular to the plane of the measuring part of the shunt.

7. The measuring apparatus according to any one of claims 1 to 6, and wherein the flat jumper (11) comprises a fourth connecting wire (18) able to connect the measuring circuit to the neutral wire (10), the input and output terminals (22, 26) of the fourth wire being arranged on the second edge of the flat jumper (11) to connect the measuring circuit to a jumper of the neutral wire arranged below the shunt (2).

8. The measuring apparatus according to any one of claims 1 to 7, and wherein the shunt (2) and the jumper of the neutral wire (10) are housed in a plastic support.

## Patentansprüche

1. Messgerät, für den Anschluss an einen Messkreislauf (1) eines Stromzählers bestimmt, einen Widerstand (2) umfassend, der mit einer ersten und einer zweiten Spannungsklemme (6, 7) ausgestattet ist, die auf einem Rand des Widerstands (2) angeordnet sind, um eine Abbildspannung des den Widerstand (2) durchfließenden elektrischen Stroms zu liefern, wobei der Abschnitt des Widerstands (2) zwischen den zwei Klemmen (6, 7) etwa flach ist, wobei das Gerät **dadurch gekennzeichnet ist, dass** es ein etwa flaches und rechteckiges Flachteil umfasst, das einen ersten und einen zweiten Verbindungsdraht (15, 16) einschließt und etwa parallel zur flachen Fläche des Widerstands (2) angeordnet ist, wobei die Eingangsterminale der Verbindungsdrähte (19, 20) auf einem der Ränder des Flachteils angeordnet sind und mit den Spannungsklemmen (6, 7) des Widerstands (2) verbunden sind und die Ausgangsterminale der Verbindungsdrähte (23, 24) auf einem zweiten Rand des Flachteils angeordnet sind, um mit einem Messkreislauf eines Zählers verbunden zu sein.

2. Messgerät nach Anspruch 1, und wobei der Widerstand (2) mit einer dritten Spannungsklemme (8) ausgestattet ist, die imstande ist, eine Versorgungsspannung zu liefern, wobei diese auf demselben Rand des Widerstands (2) wie die erste und zweite Spannungsklemme angeordnet ist, wobei das Flachteil (11) ebenfalls mit einem dritten Verbindungsdraht (17) ausgestattet ist, der ein Eingangsterminal (21) besitzt, das auf dem ersten Rand des Flachteils (11) angeordnet und mit der dritten Spannungsklemme (8) verbunden ist sowie ein Ausgangsterminal (25), das auf dem zweiten Rand des Flachteils (11) platziert ist und imstande, mit dem Messkreislauf verbunden zu sein, um ihm eine Versorgungsspannung zu liefern.

3. Messgerät nach Anspruch 1 oder 2, und wobei ein Widerstandsabschnitt (5) zwischen der ersten und der zweiten Klemme (6, 7) aus einem Werkstoff besteht, der einen relativ hohen Widerstand hat, wobei das Messen der Spannung im Verhältnis zum Strom erfolgt, der diesen Widerstandsabschnitt durchfließt.

4. Messgerät nach Anspruch 3, und wobei der Widerstand (2) einen Messabschnitt (5) umfasst, der einen hohen Widerstand besitzt und zwischen zwei Abschnitten angeordnet ist, die einen weniger hohen Widerstand besitzen, wobei die erste und die zweite Spannungsklemme (6, 7) auf den zwei Abschnitten um den Messabschnitt herum angeordnet sind.

5. Messgerät nach einem der Ansprüche 1 bis 4, und wobei das Flachteil (11) in einer vertikalen Ebene etwa parallel zu Ebene der Fläche des Widerstands (2) angeordnet ist, wobei der erste Verbindungsdraht (15) etwa vertikal und senkrecht zur Richtung des den Widerstand durchfließenden Stroms angeordnet ist, wobei der zweite Draht (16) diagonal zum ersten Draht (15) angeordnet ist, um den Abschnitt des Flachteils zu durchfließen, der sich direkt oberhalb des Messabschnitts des Widerstands befindet.

6. Messgerät nach einem der Ansprüche 1 bis 5, und wobei der Widerstand (2) U-förmig in einen Metallstreifen geschnitten ist, wobei die Glieder des Widerstands, die den Eingang (13) und den Ausgang (14) des Widerstands definieren, in der Folge gekrümmt sind, um etwa senkrecht zur Ebene des Messabschnitts des Wiederstands zu sein.

7. Messgerät nach einem der Ansprüche 1 bis 6, und wobei das Flachteil (11) einen vierten Verbindungsdraht (18) umfasst, der imstande ist, den Messkreislauf mit dem Nullleiter (10) zu verbinden, wobei die Eingangs- und Ausgangsterminale (22, 26) des vierten Drahts auf dem zweiten Rand des Flachteils (11) angeordnet sind, um den Messkreislauf mit einem Verbinder des Nullleiters zu verbinden, der unterhalb des Widerstands (2) angeordnet ist.

8. Messgerät nach einem der Ansprüche 1 bis 7, und wobei der Widerstand (2) und der Verbinder des Nullleiters (10) in einem Kunststoffhalter untergebracht sind.
